# FASCICULE DE BREVET EUROPEEN

(11) **EP 3 583 432 B1**
(45) Date de publication et mention de la délivrance du brevet: **01.06.2022**
(21) Numéro de dépôt: 18702215.7
(22) Date de dépôt: 25.01.2018
(51) Int. Cl.: G01R 22/06

(54) **PROCEDE DE VERIFICATION DU CABLAGE D'UN COMPTEUR**
VERFAHREN ZUR ÜBERPRÜFUNG DER VERDRAHTUNG EINES ZÄHLERS
METHOD FOR VERIFYING THE WIRING OF A METER

(30) Priorité: 20.02.2017 FR 1751339
(43) Date de publication de la demande: 25.12.2019
(73) Titulaire: Sagemcom Energy & Telecom SAS, 92500 Rueil-Malmaison (FR)
(72) Inventeur: TEBOULLE, Henri, 92500 Rueil Malmaison (FR); MORO, Paolo, 92500 Rueil Malmaison (FR)
(74) Mandataire: Lavaud, Thomas
(86) Numéro de dépôt international: PCT/EP2018/051893
(87) Numéro de publication internationale: WO 2018/149614

(56) Documents cités:
- WO-A1-2014/053302
- FR-A1- 2 947 055
- US-A1- 2009 261 805

## Description

### Procédé de vérification du câblage d'un compteur

L'invention concerne le domaine des procédés de vérification du câblage d'un compteur destiné à mesurer une consommation d'énergie électrique.

### ARRIERE PLAN DE L'INVENTION

L'installation d'un compteur d'énergie électrique consiste notamment à raccorder le compteur au réseau de distribution électrique et à une installation électrique dont le compteur mesure la consommation d'énergie électrique.

Il est possible qu'un installateur, en charge de l'installation du compteur, commette une erreur de câblage au moment de l'installation du compteur.

Une erreur de câblage peut par exemple consister à connecter une phase du réseau à une borne de phase aval du compteur (c'est-à-dire à une borne côté client) plutôt qu'à une borne de phase amont du compteur (c'est-à-dire à une borne côté réseau), ou bien à connecter un neutre du réseau à une borne de phase amont ou à une borne de phase aval du compteur.

Une telle erreur de câblage peut générer un sérieux dysfonctionnement du réseau, de l'installation électrique ou du compteur, voire même provoquer un incendie.

Il est connu, pour protéger une installation électrique d'un courant de court-circuit important résultant d'une telle erreur de câblage, d'utiliser un disjoncteur de protection.

On connaît notamment un disjoncteur de protection qui comporte un contact fixe, un contact mobile, une électrode de commutation située à proximité du contact fixe et du contact mobile, et un circuit de *shunt.* L'électrode de commutation capte un arc électrique provoqué par la séparation du contact fixe et du contact mobile lorsqu'un court-circuit survient. Le transfert de l'arc électrique sur l'électrode de commutation ferme le circuit *shunt*. Une grande partie du courant de court-circuit est ainsi dérivée dans le circuit *shunt,* ce qui protège l'installation électrique.

Ce type de solution nécessite l'utilisation d'un ou de plusieurs disjoncteurs tels que celui qui vient d'être décrit. Ce type de solution présente donc un certain coût et complexifie l'installation électrique.

US 2009/261805 A1, FR 2 947 055 A1 et WO 2014/053302 A1 décrivent procédés de vérification de compteurs d'énergie électriques ayant un organe de coupure entre une borne de phase amont et une borne de phase aval.

### OBJET DE L'INVENTION

L'invention a pour objet une solution simple et peu onéreuse pour protéger un réseau électrique, une installation électrique ou un compteur des effets d'une erreur de câblage du compteur.

### RESUME DE L'INVENTION

En vue de la réalisation de ce but, on propose un procédé de vérification du câblage d'un compteur destiné à mesurer une consommation d'énergie électrique fournie par un réseau à une installation électrique, le compteur comprenant une borne de phase amont, une borne de phase aval et un organe de coupure monté entre la borne de phase amont et la borne de phase aval, le procédé de vérification comprenant les étapes :
- d'ouvrir l'organe de coupure ;
- de mesurer une tension de phase amont en amont de l'organe de coupure et une tension de phase aval en aval de l'organe de coupure ;
- de détecter, en fonction d'une mesure de la tension de phase amont et d'une mesure de la tension de phase aval, une éventuelle erreur de câblage ;
- si une erreur de câblage est détectée, de générer une alerte ;
- si aucune erreur de câblage n'est détectée, de fermer l'organe de coupure et de mettre le compteur dans un mode de fonctionnement nominal.

Le compteur génère donc une alerte lorsqu'une erreur de câblage est détectée et maintient l'organe de coupure ouvert, ce qui permet de corriger l'erreur de câblage et d'éviter tout risque de dégradation du réseau, de l'installation électrique ou du compteur.

La mesure de la tension de phase amont et de la tension de phase aval peut utiliser des capteurs de tension préexistants, et la mise en œuvre du procédé de vérification du câblage d'un compteur selon l'invention est donc simple et peu onéreuse.

On propose aussi un procédé d'installation d'un compteur destiné à mesurer une consommation d'énergie électrique fournie par un réseau à une installation électrique, le compteur étant positionné en aval d'un sectionneur et comprenant une borne de phase amont, une borne de phase aval et un organe de coupure monté entre la borne de phase amont et la borne de phase aval, le procédé d'installation comprenant les étapes :
- d'ouvrir le sectionneur et l'organe de coupure ;
- de câbler le compteur ;
- de refermer le sectionneur ;
- de faire mettre en œuvre, par le compteur, le procédé de vérification décrit plus tôt.

On propose aussi un compteur destiné à mesurer une énergie électrique fournie par un réseau à une installation électrique, le compteur comprenant une borne de phase amont, une borne de phase aval et un organe de coupure monté entre la borne de phase amont et la borne de phase aval, le compteur comprenant un capteur de tension amont agencé pour mesurer une tension de phase amont en amont de l'organe de coupure, un capteur de tension aval agencé pour mesurer une tension de phase aval en aval de l'organe de coupure, et des moyens de traitement agencés pour détecter une erreur de câblage en fonction d'une mesure de la tension de phase amont et d'une mesure de la tension de phase aval, les moyens de traitement étant en outre agencés pour générer une alerte si une erreur de câblage est détectée, et pour fermer l'organe de coupure et pour mettre le compteur d'énergie électrique dans un mode de fonctionnement nominal si aucune erreur de câblage n'est détectée.

On propose de plus un programme d'ordinateur comprenant des instructions pour mettre en œuvre, par un compteur d'énergie électrique, le procédé de vérification décrit plus tôt.

On propose en outre des moyens de stockage qui stockent un programme d'ordinateur comprenant des instructions pour mettre en œuvre, par un compteur d'énergie électrique, le procédé de vérification décrit plus tôt.

D'autres caractéristiques et avantages de l'invention ressortiront à la lecture de la description qui suit de modes de réalisation particuliers non limitatifs de l'invention.

### BREVE DESCRIPTION DES DESSINS

Il sera fait référence aux dessins annexés, parmi lesquels :
- la figure 1 représente un compteur monophasé dans lequel est mis en œuvre le procédé de vérification du câblage d'un compteur selon un premier mode de réalisation de l'invention ;
- la figure 2 représente les étapes du procédé de vérification du câblage d'un compteur selon le premier mode de réalisation de l'invention ;
- la figure 3 représente un compteur triphasé dans lequel est mis en œuvre le procédé de vérification du câblage d'un compteur selon un deuxième mode de réalisation de l'invention ;
- la figure 4 représente les étapes du procédé de vérification du câblage d'un compteur selon le deuxième mode de réalisation de l'invention.

### DESCRIPTION DETAILLEE DE L'INVENTION

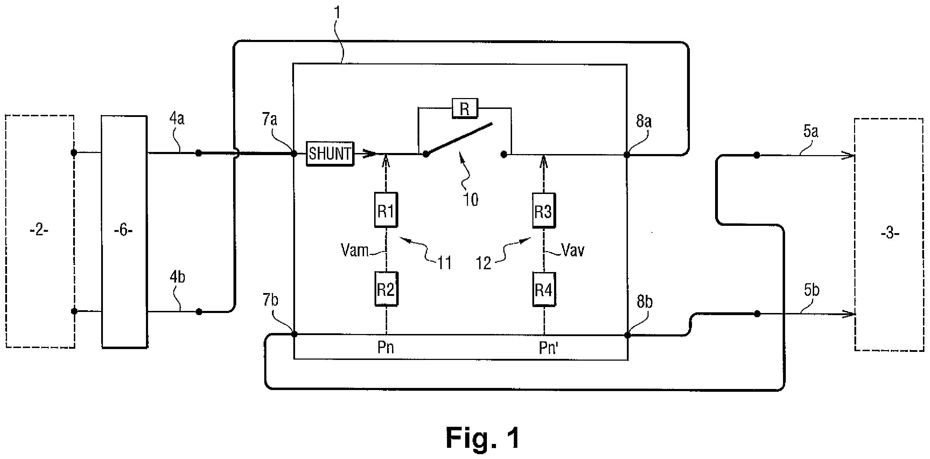

En référence à la figure 1, le procédé de vérification du câblage d'un compteur selon un premier mode de réalisation de l'invention est ici mis en œuvre sur un compteur monophasé 1.

Le compteur 1 est destiné à mesurer une consommation d'énergie électrique fournie par un réseau de distribution électrique 2 à une installation électrique 3. Le réseau comporte un conducteur de phase 4a et un conducteur de neutre 4b. La tension du réseau 2 est une tension alternative de fréquence égale 50Hz et de tension efficace égale 230V. L'installation 3 reçoit l'énergie électrique par un conducteur de phase 5a et un conducteur de neutre 5b.

Un sectionneur 6 est positionné du côté du réseau 2, pour pouvoir isoler du réseau 2 l'installation 3 lorsque cela est nécessaire.

Le compteur 1 comporte une borne de phase amont 7a, une borne de phase aval 8a, une borne de neutre amont 7b et une borne de neutre aval 8b.

La borne de phase amont 7a est destinée à être connectée au conducteur de phase 4a du réseau 2. La borne de phase aval 8a est destinée à être connectée au conducteur de phase 5a de l'installation 3. La borne de neutre amont 7b est destinée à être connectée au conducteur de neutre 4b du réseau 2. La borne de neutre aval 8b est destinée à être connectée au conducteur de neutre 5b de l'installation 3.

Le compteur 1 comporte de plus un organe de coupure 10 monté entre la borne de phase amont 7a et la borne de phase aval 8a. L'organe de coupure 10 permet de sélectivement connecter et déconnecter, à distance, l'installation 3 du réseau 2.

Le compteur 1 comporte en outre un capteur de tension de phase amont 11 et un capteur de tension de phase aval 12.

La tension de phase amont Vam est une tension dans le compteur 1 en amont de l'organe de coupure 10. La tension de phase amont Vam est ici égale à une différence de potentiels entre un point en amont de l'organe de coupure 10 et un point du neutre Pn.

La tension de phase aval Vav est une tension dans le compteur 1 en aval de l'organe de coupure 10. La tension de phase aval Vav est ici égale à une différence de potentiels entre un point en aval de l'organe de coupure 10 et un point du neutre P'n équipotentiel du point de neutre Pn.

On note que, dans le compteur monophasé 1, le neutre est flottant. Le potentiel des points de neutre Pn, P'n est donc différent d'un potentiel proche de celui de la terre.

Le capteur de tension amont 11 et le capteur de tension aval 12 sont chacun symbolisés par deux résistances, mais ils sont en réalité possiblement plus complexes.

Le compteur 1 comporte aussi des moyens de traitement, non représentés, qui comprennent un composant de traitement intelligent (par exemple un processeur, un microcontrôleur ou un FPGA) adapté à exécuter des instructions d'un programme pour mettre en œuvre le procédé de vérification du câblage d'un compteur selon le premier mode de réalisation de l'invention. Le composant de traitement intelligent remplit d'autres fonctions, et est notamment adapté à gérer le fonctionnement du compteur, à commander l'organe de coupure, à acquérir et à traiter les mesures réalisées par les capteurs de tension, etc.

Le compteur 1 comporte bien sûr d'autres éléments non décrits ici, et notamment des moyens de mesure de la consommation d'énergie électrique de l'installation 3.

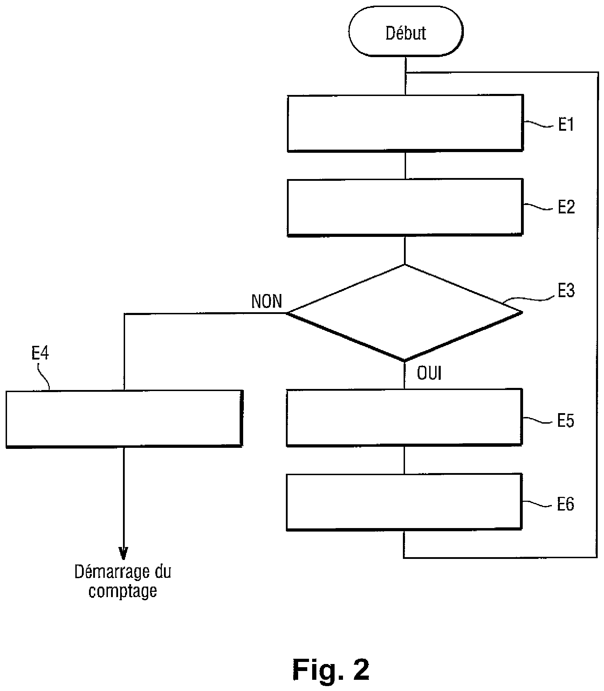

On décrit maintenant, en référence à la figure 2, les étapes de l'installation du compteur 1 et du procédé de vérification du câblage d'un compteur selon le premier mode de réalisation de l'invention.

L'installation du compteur 1 est réalisée par un installateur.

Lorsque débute l'installation, le sectionneur 6 et l'organe de coupure 10 sont ouverts.

L'ouverture de l'organe de coupure 10 est réalisée en usine, à l'issue de la fabrication du compteur 1, ou bien est réalisée par les moyens de traitement du compteur 1 dès le démarrage du compteur 1.

L'installateur installe le compteur 1 à l'emplacement prévu, puis raccorde le compteur 1 au réseau 2 et à l'installation 3. Lorsque l'installateur a terminé le câblage du compteur 1, il referme le sectionneur 6 (étape E1).

Le compteur 1 démarre alors.

Les capteurs de tension 11, 12 mesurent la tension de phase amont Vam et la tension de phase aval Vav.

Les moyens de traitement acquièrent les mesures de la tension de phase amont Vam et de la tension de phase aval Vav et mesurent un premier déphasage ϕ1 entre la tension de phase amont Vam et la tension de phase aval Vav. La mesure du premier déphasage ϕ1 utilise une méthode du type « Zéro Crossing » (étape E2). Tous les déphasages de ce document sont exprimés en degrés et compris dans la plage [0° ; 360°[.

Si le câblage a été correctement réalisé, la tension de phase amont Vam (ou, plus exactement, la valeur efficace de la tension de phase amont Vam) devrait être proche de 230V, et la tension de phase aval Vav (ou, plus exactement, la valeur efficace de la tension de phase aval Vav) devrait être proche de 0V (typiquement inférieure à 10V).

Dans ce qui suit, les comparaisons des différentes tensions avec les différents seuils de tension concernent les valeurs efficaces des différentes tensions.

Dans le cas de l'erreur de câblage représentée sur la figure 1, où le conducteur de neutre 4b du réseau 2 a été connecté à la borne de phase aval 8a du compteur 1 et où le conducteur de phase 5a de l'installation 3 a été connecté à la borne de neutre amont 7b du compteur 1, cette condition n'est pas vérifiée.

Dans ce cas (et lorsque le réseau 2 ne comporte pas de panne franche), comme le neutre est flottant, un équilibre s'établit entre la tension de phase amont Vam et la tension de phase aval Vav. La tension de phase amont Vam et la tension de phase aval Vav se retrouvent en opposition de phase. La tension de phase amont Vam et la tension de phase aval Vav présentent chacune une valeur efficace proche de la moitié de 230V, soit proche de 115V.

Les moyens de traitement vérifient donc les trois conditions suivantes (étape E3), et détectent une erreur de câblage lorsque les trois conditions suivantes sont vérifiées :
- le premier déphasage ϕ1 est tel que : 180°-x1≤ϕ1≤180°+x1, où x1 est un premier seuil de phase prédéterminé compris entre 1° et 10° (ici, x1 est égal à 5°);
- la tension de phase amont Vam est supérieure à un seuil de tension prédéfini ;
- la tension de phase aval Vav est supérieure au seuil de tension prédéfini.

Le seuil de tension prédéfini est ici choisi égal à 75V.

Ainsi, si ces trois conditions ne sont pas vérifiées, une erreur de câblage n'est pas détectée, et les moyens de traitement du compteur 1 ferment l'organe de coupure 10 (étape E4) et mettent le compteur 1 dans un mode de fonctionnement nominal. Le compteur 1 commence à mesurer la consommation d'énergie électrique de l'installation 3.

Par contre, si ces trois conditions sont vérifiées, les moyens de traitement détectent l'erreur de câblage et produisent une alerte pour avertir l'installateur de son erreur (étape E5). L'alerte est générée par le clignotement d'une diode électroluminescente du compteur 1, ou bien par un affichage d'un message d'alerte sur un écran du compteur 1. L'écran du compteur 1 est par exemple un écran à cristaux liquides.

Dès lors qu'une alerte est produite, l'organe de coupure 10 est maintenu ouvert par les moyens de traitement. L'installateur ouvre le sectionneur 6 (étape E6), déconnecte le compteur 1 et recommence le câblage du compteur 1 pour corriger l'erreur de câblage.

L'installation du compteur recommence alors au niveau de l'étape E1.

On note qu'un autre type d'erreur de câblage peut aussi être détecté.

Lorsque les moyens de traitement détectent que la tension de phase amont Vam est proche de 0V et que la tension de phase aval Vav est proche de la tension du réseau 2 (230V), les moyens de traitement vérifient si l'installation 3 est productrice d'énergie électrique ou non.

Les moyens de traitement vérifient cette condition en vérifiant que la tension de phase aval Vav est supérieure à un premier seuil de tension haute prédéfini et que la tension de phase amont Vam est inférieure à un premier seuil de tension basse prédéfini.

Si l'installation 3 n'est pas productrice d'énergie électrique, une erreur de câblage est détectée. Cette erreur de câblage correspond à un câblage du conducteur de phase 4a du réseau 2 à la borne de phase aval 8a du compteur 1, et du conducteur de phase 5a de l'installation 3 à la borne de phase amont 7a du compteur 1.

Les moyens de traitement produisent alors une alerte pour avertir l'installateur de son erreur.

Dès lors qu'une alerte est produite, l'organe de coupure 10 est maintenu ouvert par les moyens de traitement. L'installateur ouvre le sectionneur 6, déconnecte le compteur 1 et recommence le câblage du compteur 1 pour corriger l'erreur de câblage.

Cependant, un cas dans lequel la tension de phase amont Vam est proche de la tension du réseau 2 et dans lequel la tension de phase aval Vav est proche de la tension du réseau 2 peut aussi correspondre à une installation 3 productrice d'énergie électrique. L'installation 3 comporte dans ce cas des moyens de production d'énergie électrique (par exemple, des panneaux solaires). Le client fournit tout ou partie de l'énergie électrique produite par l'installation 3 au réseau 2.

Ainsi, lorsque les moyens de traitement détectent que la tension de phase amont Vam est proche de la tension du réseau 2 et que la tension de phase aval Vav est proche de la tension du réseau 2, les moyens de traitement ne sont pas en mesure de déterminer s'il s'agit d'une erreur de câblage ou bien d'une installation 3 qui est productrice d'énergie électrique.

On note dans ce cas que la mesure du déphasage ϕ1 entre la tension de phase amont Vam et la tension de phase aval Vav, mesuré par une méthode de type « Zéro Crossing », est tel que 360°-x2≤ϕ1≤x2, où x2 est un deuxième seuil de phase prédéterminé compris entre 1° et 4° (typiquement x2 = 3°), ne peut permettre de déterminer s'il s'agit d'une erreur de câblage ou non. En effet, lorsque l'installation 3 est productrice d'énergie électrique, un coupleur de l'installation 3 synchronise la tension de phase aval Vav avec la tension de phase amont Vam.

Cette erreur de câblage ne présente pas de risque d'incendie.

Dans ce cas, les moyens de traitement génèrent un message à destination du fournisseur d'énergie électrique ou du gestionnaire du réseau 2. Le message est transmis par courants porteurs en ligne ou par tout autre type de moyen de communication (filaire ou sans fil). Dans le cas où des courants porteurs en ligne sont choisis, les couches applicatives DLMS ou COSEM sont avantageusement utilisées.

Le message résume la situation et indique que l'installation 3 semble être productrice d'énergie électrique. Le fournisseur d'énergie électrique ou le gestionnaire du réseau 2 vérifie si l'installation 3 est bien productrice d'énergie électrique et donc si la situation est normale ou non. Si la situation est anormale, le fournisseur d'énergie électrique ou le gestionnaire du réseau 2 envoie à nouveau l'installateur auprès du compteur 1 pour corriger l'erreur de câblage.

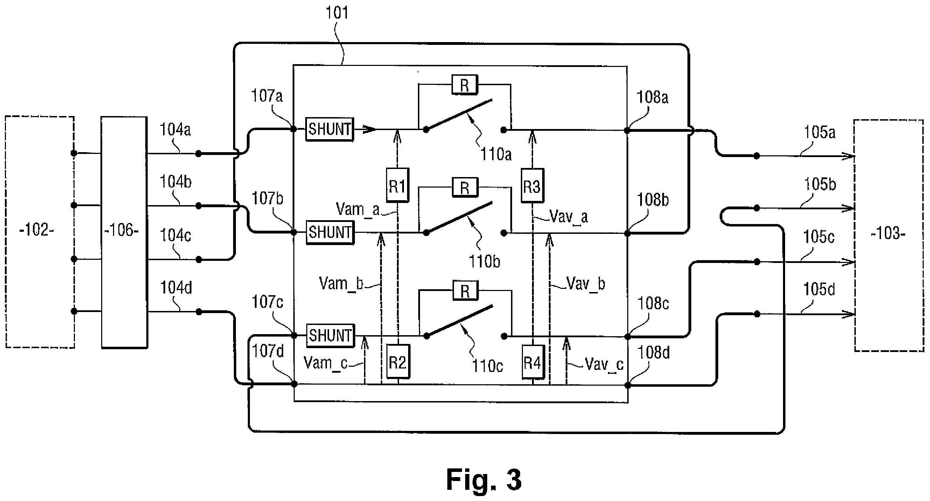

En référence à la figure 3, le procédé de vérification du câblage d'un compteur selon un deuxième mode de réalisation de l'invention est ici mis en œuvre sur un compteur triphasé 101.

Le réseau 102 comporte trois conducteurs de phase 104a, 104b, 104c et un conducteur de neutre 104d. La tension du réseau 102 est une tension alternative de fréquence égale 50Hz et de tension efficace égale 230V. L'installation 103 reçoit l'énergie électrique par trois conducteurs de phase 105a, 105b, 105c et un conducteur de neutre 105d.

Un sectionneur 106 est positionné du côté du réseau 102 pour pouvoir isoler du réseau 102 l'installation 103 lorsque cela est nécessaire.

Le compteur 101 comporte trois bornes de phase amont 107a, 107b, 107c, trois bornes de phase aval 108a, 108b, 108c, une borne de neutre amont 107d et une borne de neutre aval 108d.

Le compteur 101 comporte de plus un organe de coupure 110a, 110b, 110c monté entre chaque borne de phase amont 107 et la borne de phase aval 108 correspondante.

Le compteur 101 comporte en outre des capteurs de tension de phase amont et des capteurs de tension de phase aval. Les capteurs de tension de phase amont mesurent les tensions de phase amont Vam_a, Vam_b, Vam_c. Les capteurs de tension de phase aval mesurent les tensions de phase aval Vav_a, Vav_b, Vav_c.

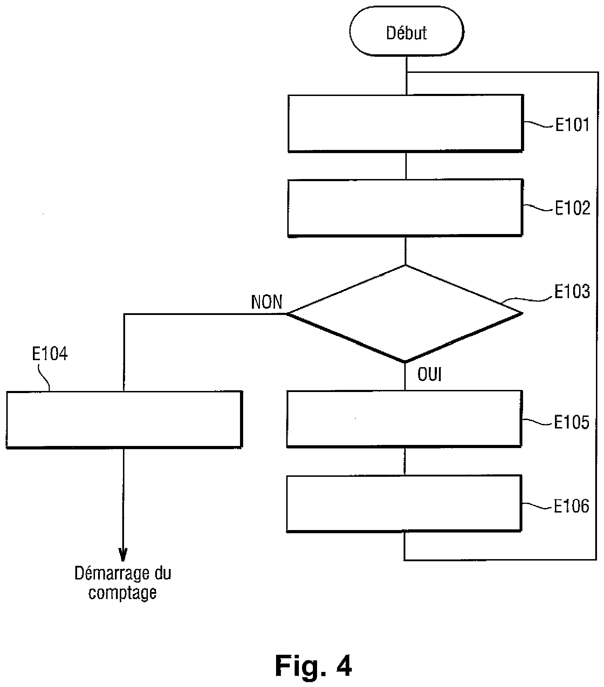

On décrit maintenant, en référence à la figure 4, les étapes de l'installation du compteur 101 et du procédé de vérification du câblage d'un compteur selon le deuxième mode de réalisation de l'invention.

L'installation du compteur 101 est réalisée par un installateur.

Lorsque débute l'installation, le sectionneur 106 et les organes de coupure 110 sont ouverts. Lorsque l'installateur a terminé le câblage du compteur 101, il referme le sectionneur 106. Le compteur démarre alors (étape E101). L'ouverture des organes de coupure 110 est réalisée en usine, à l'issue de la fabrication du compteur 101, ou bien est réalisée par les moyens de traitement du compteur 101 dès le démarrage du compteur 101.

Les capteurs de tension mesurent les tensions de phase amont Vam_a, Vam_b, Vam_c et les tensions de phase aval Vav_a, Vav_b, Vav_c (étape E102).

Si le câblage a été correctement réalisé, chaque tension de phase amont Vam devrait être proche de la tension du réseau, soit 230V, et chaque tension de phase aval Vav devrait être proche de 0V.

Dans le cas de l'erreur de câblage représentée sur la figure 3, où le conducteur de phase 104c du réseau 102 a été connecté à la borne de phase aval 108b du compteur 101 et où le conducteur de phase 105b de l'installation 103 a été connecté à la borne de phase amont 107c du compteur 101, la tension de phase amont Vam_c est au contraire proche de 0V et la tension de phase aval Vav_b est au contraire proche de 230V.

Les moyens de traitement détectent l'erreur de câblage lorsque l'une des tensions de phase amont Vam est inférieure à un deuxième seuil de tension basse prédéfini et lorsque l'une des tensions de phase aval Vav est supérieure à un deuxième seuil de tension haute prédéfini.

Les moyens de traitement vérifient donc cette condition (étape E103).

Le deuxième seuil de tension basse prédéfini est ici égal à 10V et le deuxième seuil de tension haute prédéfini est ici égal à 176V.

Si cette condition n'est pas vérifiée, une erreur de câblage n'est pas détectée, et les moyens de traitement du compteur 101 ferment les organes de coupure 110 et mettent le compteur 101 dans un mode de fonctionnement nominal (étape E104). Le compteur 101 commence à mesurer la consommation d'énergie électrique de l'installation 103.

Par contre, si cette condition est vérifiée, les moyens de traitement détectent l'erreur de câblage et produisent une alerte pour avertir l'installateur de son erreur (étape E105).

Dès lors qu'une alerte est produite, les organes de coupure 110 sont maintenus ouverts par les moyens de traitement. L'installateur ouvre le sectionneur 106, déconnecte le compteur 101 et recommence le câblage du compteur 101 pour corriger l'erreur de câblage (étape E106) .

Si l'on considère que l'installation 103 peut être productrice d'énergie électrique, il se peut qu'il y ait une tension de phase aval Vav supérieure au deuxième seuil de tension haute prédéfini, par exemple la tension de phase aval Vav_b, alors même qu'aucune erreur de câblage n'ait été commise.

Dans ce cas, les moyens de traitement mesurent en complément un deuxième déphasage ϕ2 entre la tension de phase aval Vav_b et la tension de phase amont Vam_b correspondante, et un troisième déphasage ϕ3 entre la tension de phase aval Vav_b et une autre tension de phase amont, par exemple la tension de phase amont Vam_a.

Les moyens de traitement vérifient que les déphasages ϕ2 et ϕ3 sont bien tels que :
120°-x3≤ϕ2≤120°+x3 ou 240°-x3≤ϕ2≤240°+x3, et
240°-x3≤ϕ3≤240°+x3 ou 120°-x3≤ϕ3≤120°+x3,
où x3 est un troisième seuil de phase prédéterminé compris entre 1° et 10° (ici, x3 est égal à 2°).

La mesure des déphasages ϕ2, ϕ3 utilise une méthode du type « Zéro Crossing ».

Les moyens de traitement vérifient que les déphasages ϕ2, ϕ3 sont cohérents par rapport à l'ordre des déphasages lorsque l'installation 103 est productrice (la tension de phase aval Vav_b et la tension de phase amont Vam_b correspondantes sont en phase).

Dans le cas où, pour une même phase, le câblage à la borne de phase amont 107 et le câblage à la borne de phase aval 108 ont été inversés, et dans le cas où l'installation 103 n'est pas productrice d'énergie électrique, les moyens de traitement détermineront que la tension de phase amont Vam est proche de 0V (soit inférieure au deuxième seuil de tension basse prédéterminé), et que la tension de phase aval Vav est proche de 230V (soit supérieure au deuxième seuil de tension haute prédéterminé).

Les moyens de traitement produisent une alerte pour avertir l'installateur de son erreur. Il n'y a pas de risque d'incendie dans ce cas.

L'installation du compteur recommence alors au niveau de l'étape E101.

Cependant, si l'installation 103 est productrice d'énergie électrique, la tension de phase amont Vam et la tension de phase aval Vav sont synchronisées et une telle erreur de câblage ne sera pas détectée directement. Il n'y a pas de risque d'incendie dans ce cas. L'erreur de câblage ne sera pas non plus visible sur les phases de la tension de phase amont Vam et de la tension de phase aval Vav qui sont synchronisées. On mesure dans ce cas une tension de phase amont supérieure au deuxième seuil de tension haute prédéfini et une tension de phase aval correspondante supérieure au deuxième seuil de tension haute prédéfini, et un quatrième déphasage ϕ4 entre ces deux tensions, mesuré par une méthode de type « Zéro Crossing », est tel que 360°-x4≤ϕ4≤x4, où x4 est un quatrième seuil de phase prédéterminé compris entre 1° et 4° (typiquement x4 = 3°).

Dans ce cas, les moyens de traitement génèrent un message à destination du fournisseur d'énergie électrique ou du gestionnaire du réseau 102. Le message est transmis par courants porteurs en ligne ou par tout autre type de moyen de communication (filaire ou sans fil). Dans le cas où des courants porteurs en ligne sont choisis, les couches applicatives DLMS ou COSEM sont avantageusement utilisées.

Le message résume la situation et indique que l'installation 103 semble être productrice d'énergie électrique. Le fournisseur d'énergie électrique ou le gestionnaire du réseau 102 vérifie si l'installation 103 est bien productrice d'énergie électrique et donc si la situation est normale ou non. Si la situation est anormale, le fournisseur d'énergie électrique ou le gestionnaire du réseau 102 envoie à nouveau l'installateur auprès du compteur 101 pour corriger l'erreur de câblage.

Bien entendu, l'invention n'est pas limitée aux modes de réalisation décrits mais englobe toute variante entrant dans le champ de l'invention telle que définie par les revendications.

On a ici mis en œuvre l'invention sur un compteur monophasé et sur un compteur triphasé, mais l'invention s'applique à tout compteur polyphasé quel que soit le nombre de phases.

On a illustré l'invention en expliquant comment certaines erreurs de câblage sont détectées, mais l'invention permet aussi de détecter d'autres erreurs de câblage.

Les valeurs numériques qui sont fournies ici, notamment pour les seuils de tension prédéfinis et les seuils de phase prédéfinis, pourraient bien sûr être différentes. De même, l'invention peut tout aussi bien s'appliquer avec des valeurs numériques différentes au cas d'un réseau de fourniture électrique 60Hz / 110V.

## Revendications

1. Procédé de vérification du câblage d'un compteur destiné à mesurer une consommation d'énergie électrique fournie par un réseau (2 ; 102) à une installation électrique (3 ; 103), le procédé de vérification étant destiné à vérifier que le câblage a été correctement réalisé, le compteur (1 ; 101) comprenant une borne de phase amont (7a ; 107), une borne de phase aval (8a ; 108) et un organe de coupure (10 ; 110) monté entre la borne de phase amont et la borne de phase aval, le procédé de vérification comprenant les étapes :
- d'ouvrir l'organe de coupure ;
- de mesurer une tension de phase amont (Vam) en amont de l'organe de coupure et une tension de phase aval (Vav) en aval de l'organe de coupure ;
- de détecter, en fonction d'une mesure de la tension de phase amont et d'une mesure de la tension de phase aval, une éventuelle erreur de câblage ;
- si une erreur de câblage est détectée, de générer une alerte ;
- si aucune erreur de câblage n'est détectée, de fermer l'organe de coupure et de mettre le compteur dans un mode de fonctionnement nominal.

2. Procédé de vérification selon la revendication 1, dans lequel le compteur est un compteur monophasé (1), et dans lequel l'erreur de câblage est détectée aussi en fonction d'une mesure d'un premier déphasage entre la tension de phase amont (Vam) et la tension de phase aval (Vav).

3. Procédé de vérification selon la revendication 2, dans lequel l'erreur de câblage est détectée lorsque les trois conditions suivantes sont réunies :
- le premier déphasage (ϕ1) est tel que : 180°-x1≤ϕ1≤180°+x1, où x1 est un premier seuil de phase prédéterminé compris entre 1° et 10° ;
- la tension de phase amont (Vam) est supérieure à un seuil de tension prédéfini ;
- la tension de phase aval (Vav) est supérieure au seuil de tension prédéfini.

4. Procédé de vérification selon la revendication 2, dans lequel le premier déphasage est mesuré en utilisant une méthode de type « Zéro Crossing ».

5. Procédé de vérification selon la revendication 2, comprenant en outre, si la tension de phase aval (Vav) est supérieure à un premier seuil de tension haute prédéfini et si la tension de phase amont (Vam) est inférieure à un premier seuil de tension basse prédéfini, une étape consistant à générer un message pour vérifier si l'installation électrique (3) est productrice d'énergie électrique ou non.

6. Procédé de vérification selon la revendication 2, comprenant en outre, si la tension de phase aval (Vav) est supérieure à un premier seuil de tension haute prédéfini et si la tension de phase amont (Vam) est supérieure à un premier seuil de tension haute prédéfini, et si le premier déphasage (ϕ1) est tel que 360°-x2≤ϕ1≤x2, où x2 est un deuxième seuil de phase prédéterminé compris entre 1° et 10°, une étape consistant à générer un message pour vérifier si l'installation électrique (3) est productrice d'énergie électrique ou non.

7. Procédé de vérification selon la revendication 1, dans lequel le compteur est un compteur triphasé (101) comprenant trois bornes de phase amont (107a, 107b, 107c), trois bornes de phase aval (108a, 108b, 108c) et un organe de coupure (110a, 110b, 110c) monté entre chaque borne de phase amont et la borne de phase aval correspondante, et dans lequel l'erreur de câblage est détectée lorsque l'une des tensions de phase amont est inférieure à un deuxième seuil de tension basse prédéfini et lorsque l'une des tensions de phase aval est supérieure à un deuxième seuil de tension haute prédéfini.

8. Procédé de vérification selon la revendication 7, comprenant en outre, si l'une des tensions de phase aval est supérieure au deuxième seuil de tension haute prédéfini, une étape consistant à mesurer un deuxième déphasage entre la tension de phase aval supérieure au deuxième seuil de tension haute prédéfini et la tension de phase amont correspondante, et à mesurer un troisième déphasage entre la tension de phase aval supérieure au deuxième seuil de tension haute prédéfini et une autre tension de phase amont.

9. Procédé de vérification selon la revendication 8, comprenant en outre une étape consistant à vérifier que le deuxième déphasage (ϕ2) et le troisième déphasage (ϕ3) sont tels que :
120°-x3≤ϕ2≤120°+x3 ou 240°-x3≤ϕ2≤240°+x3 et 240°-x3≤ϕ3≤240°+x3 ou 120°-x3≤ϕ3≤120°+x3, où x3 est un troisième seuil de phase prédéterminé compris entre 1° et 10°.

10. Procédé de vérification selon la revendication 8, dans lequel le deuxième déphasage et le troisième déphasage sont mesurés en utilisant une méthode de type « Zéro Crossing ».

11. Procédé de vérification selon la revendication 7, comprenant en outre, si une tension de phase amont est inférieure au deuxième seuil de tension basse prédéfini et si la tension de phase aval correspondante est supérieure au deuxième seuil de tension haute prédéfini, une étape consistant à générer un message pour vérifier si l'installation électrique (103) est productrice d'énergie électrique ou non.

12. Procédé de vérification selon la revendication 7, comprenant en outre, si une tension de phase amont est supérieure au deuxième seuil de tension haute prédéfini et si la tension de phase aval correspondante est supérieure au deuxième seuil de tension haute prédéfini, et si un quatrième déphasage (ϕ4) entre ces deux tensions est tel que 360°-x4≤ϕ4≤x4, où x4 est un quatrième seuil de phase prédéterminé compris entre 1° et 10°, une étape consistant à générer un message pour vérifier si l'installation électrique (103) est productrice d'énergie électrique ou non.

13. Procédé de vérification selon la revendication 1, dans lequel l'alerte indique à un installateur du compteur (1 ; 101) que l'erreur de câblage a été détectée.

14. Procédé de vérification selon la revendication 13, dans lequel l'alerte est générée par une diode électroluminescente du compteur (1 ; 101).

15. Procédé de vérification selon la revendication 13, dans lequel l'alerte est générée par un affichage d'un message d'alerte sur un écran du compteur (1 ; 101).

16. Procédé d'installation d'un compteur destiné à mesurer une consommation d'énergie électrique fournie par un réseau (2 ; 102) à une installation électrique (3 ; 103), le compteur (1 ; 101) étant positionné en aval d'un sectionneur (6 ; 106) et comprenant une borne de phase amont (7a ; 107), une borne de phase aval (8a ; 108) et un organe de coupure (10 ; 110) monté entre la borne de phase amont et la borne de phase aval, le procédé d'installation comprenant les étapes :
- d'ouvrir le sectionneur ;
- de câbler le compteur (1 ; 101) ;
- de refermer le sectionneur ;
- de faire mettre en œuvre, par le compteur, le procédé de vérification selon l'une des revendications précédentes.

17. Compteur destiné à mesurer une énergie électrique fournie par un réseau à une installation électrique, le compteur étant agencé pour vérifier que son câblage a été correctement réalisé, le compteur comprenant une borne de phase amont, une borne de phase aval et un organe de coupure monté entre la borne de phase amont et la borne de phase aval, le compteur comprenant un capteur de tension amont agencé pour mesurer une tension de phase amont en amont de l'organe de coupure, un capteur de tension aval agencé pour mesurer une tension de phase aval en aval de l'organe de coupure, et des moyens de traitement agencés pour détecter une erreur de câblage en fonction d'une mesure de la tension de phase amont et d'une mesure de la tension de phase aval, les moyens de traitement étant en outre agencés pour générer une alerte si une erreur de câblage est détectée, et pour fermer l'organe de coupure et pour mettre le compteur d'énergie électrique dans un mode de fonctionnement nominal si aucune erreur de câblage n'est détectée.

18. Programme d'ordinateur comprenant des instructions pour mettre en œuvre, par un compteur d'énergie électrique, le procédé de vérification selon l'une des revendications 1 à 15.

19. Moyens de stockage, **caractérisés en ce qu'**ils stockent un programme d'ordinateur comprenant des instructions pour mettre en œuvre, par un compteur d'énergie électrique, le procédé de vérification selon l'une des revendications 1 à 15.

## Patentansprüche

1. Verfahren zur Überprüfung der Verdrahtung eines Zählers, der dazu bestimmt ist, einen Verbrauch einer elektrischen Energie zu messen, die von einem Netzwerk (2; 102) an eine elektrische Anlage (3; 103) geliefert wird, wobei das Überprüfungsverfahren dazu bestimmt ist, zu überprüfen, ob die Verdrahtung korrekt ausgeführt worden ist, wobei der Zähler (1; 101) eine stromaufwärtige Phasenklemme (7a; 107), eine stromabwärtige Phasenklemme (8a; 108) und ein Abschaltorgan (10; 110) umfasst, das zwischen der stromaufwärtigen Phasenklemme und der stromabwärtigen Phasenklemme geschaltet ist, wobei das Überprüfungsverfahren die Schritte umfasst:
- Öffnen des Abschaltorgans;
- Messen einer stromaufwärtigen Phasenspannung (Vam) stromaufwärts des Abschaltorgans und einer stromabwärtigen Phasenspannung (Vav) stromabwärts des Abschaltorgans;
- Erfassen eines möglichen Verdrahtungsfehlers in Abhängigkeit von einer Messung der stromaufwärtigen Phasenspannung und einer Messung der stromabwärtigen Phasenspannung;
- wenn ein Verdrahtungsfehler erfasst wird, Erzeugen eines Alarms;
- wenn kein Verdrahtungsfehler erfasst wird, Schließen des Abschaltorgans und Versetzen des Zählers in einen nominalen Betriebsmodus.

2. Überprüfungsverfahren nach Anspruch 1, bei dem der Zähler ein Einphasen-Zähler (1) ist, und bei dem der Verdrahtungsfehler auch in Abhängigkeit von einer Messung einer ersten Phasenverschiebung zwischen der stromaufwärtigen Phasenspannung (Vam) und der stromabwärtigen Phasenspannung (Vav) erfasst wird.

3. Überprüfungsverfahren nach Anspruch 2, bei dem der Verdrahtungsfehler erfasst wird, wenn die drei folgenden Bedingungen erfüllt sind:
- die erste Phasenverschiebung (ϕ1) ist derart, dass:
180°-x1≤ϕ1≤180°+x1, wobei x1 ein vorbestimmter erster Phasenschwellenwert zwischen 1° und 10° ist;
- die stromaufwärtige Phasenspannung (Vam) größer als ein vordefinierter Spannungsschwellenwert ist;
- die stromabwärtige Phasenspannung (Vav) größer als der vordefinierte Spannungsschwellenwert ist.

4. Überprüfungsverfahren nach Anspruch 2, bei dem die erste Phasenverschiebung gemessen wird, indem ein Verfahren vom Typ "Nulldurchgang" verwendet wird.

5. Überprüfungsverfahren nach Anspruch 2, ferner umfassend, wenn die stromabwärtige Phasenspannung (Vav) größer als ein vordefinierter erster oberer Spannungsschwellenwert ist und wenn die stromaufwärtige Phasenspannung (Vam) kleiner als ein vordefinierter erster unterer Spannungsschwellenwert ist, einen Schritt, der darin besteht, eine Nachricht zu erzeugen, um zu überprüfen, ob die elektrische Anlage (3) elektrische Energie erzeugt oder nicht.

6. Überprüfungsverfahren nach Anspruch 2, ferner umfassend, wenn die stromabwärtige Phasenspannung (Vav) größer als ein vordefinierter erster oberer Spannungsschwellenwert ist und wenn die stromaufwärtige Phasenspannung (Vam) größer als ein vordefinierter erster oberer Spannungsschwellenwert ist, und wenn die erste Phasenverschiebung (ϕ1) derart ist, dass 360°-x2≤ϕ1≤x2 ist, wobei x2 ein vorbestimmter zweiter Phasenschwellenwert zwischen 1° und 10° ist, einen Schritt, der darin besteht, eine Nachricht zu erzeugen, um zu überprüfen, ob die elektrische Anlage (3) elektrische Energie erzeugt oder nicht.

7. Überprüfungsverfahren nach Anspruch 1, bei dem der Zähler ein Dreiphasen-Zähler (101) ist, der drei stromaufwärtige Phasenklemmen (107a, 107b, 107c), drei stromabwärtige Phasenklemmen (108a, 108b, 108c) und ein Abschaltorgan (110a, 110b, 110c) umfasst, das zwischen jeder stromaufwärtigen Phasenklemme und der entsprechenden stromabwärtigen Phasenklemme geschaltet ist, und bei dem der Verdrahtungsfehler erfasst wird, wenn eine der stromaufwärtigen Phasenspannungen kleiner als ein vordefinierter zweiter unterer Spannungsschwellenwert ist, und wenn eine der stromabwärtigen Phasenspannungen größer als ein vordefinierter zweiter oberer Spannungsschwellenwert ist.

8. Überprüfungsverfahren nach Anspruch 7, ferner umfassend, wenn eine der stromabwärtigen Phasenspannungen größer als ein vordefinierter zweiter oberer Spannungsschwellenwert ist, einen Schritt, der darin besteht, eine zweite Phasenverschiebung zwischen der stromabwärtigen Phasenspannung, die größer als der vordefinierte zweite obere Spannungsschwellenwert ist, und der entsprechenden stromaufwärtigen Phasenspannung zu messen, und eine dritte Phasenverschiebung zwischen der stromabwärtigen Phasenspannung, die größer als der vordefinierte zweite obere Spannungsschwellenwert ist, und einer anderen stromaufwärtigen Phasenspannung zu messen.

9. Überprüfungsverfahren nach Anspruch 8, ferner umfassend einen Schritt, der darin besteht, zu überprüfen, ob die zweite Phasenverschiebung (ϕ2) und die dritte Phasenverschiebung (ϕ3) derart sind, dass:
120°-x3≤ϕ2≤120°+x3 oder 240°-x3≤ϕ2≤240°+x3 und
240°-x3≤ϕ3≤240°+x3 oder 120°-x3≤ϕ3≤120°+x3, wobei x3 ein vorbestimmter dritter Phasenschwellenwert zwischen 1° und 10° ist.

10. Überprüfungsverfahren nach Anspruch 8, bei dem die zweite Phasenverschiebung und die dritte Phasenverschiebung gemessen werden, indem ein Verfahren vom Typ "Nulldurchgang" verwendet wird.

11. Überprüfungsverfahren nach Anspruch 7, ferner umfassend, wenn eine stromaufwärtige Phasenspannung kleiner als der vordefinierte zweite untere Spannungsschwellenwert ist und wenn die entsprechende stromabwärtige Phasenspannung größer als der vordefinierte zweite obere Spannungsschwellenwert ist, einen Schritt, der darin besteht, eine Nachricht zu erzeugen, um zu überprüfen, ob die elektrische Anlage (103) elektrische Energie erzeugt oder nicht.

12. Überprüfungsverfahren nach Anspruch 7, ferner umfassend, wenn eine stromaufwärtige Phasenspannung größer als ein vordefinierter zweiter oberer Spannungsschwellenwert ist und wenn die entsprechende stromabwärtige Phasenspannung größer als ein vordefinierter zweiter oberer Spannungsschwellenwert ist, und wenn eine vierte Phasenverschiebung (ϕ4) zwischen diesen beiden Spannungen derart ist, dass 360°-x4≤ϕ4≤x4, wobei x4 ein vorbestimmter vierter Phasenschwellenwert zwischen 1° und 10° ist, einen Schritt, der darin besteht, eine Nachricht zu erzeugen, um zu überprüfen, ob die elektrische Anlage (103) elektrische Energie erzeugt oder nicht.

13. Überprüfungsverfahren nach Anspruch 1, bei dem der Alarm einem Installateur des Zählers (1; 101) anzeigt, dass der Verdrahtungsfehler erfasst wurde.

14. Überprüfungsverfahren nach Anspruch 13, bei dem der Alarm von einer Elektrolumineszenzdiode des Zählers (1; 101) erzeugt wird.

15. Überprüfungsverfahren nach Anspruch 13, bei dem der Alarm durch eine Anzeige einer Alarmnachricht auf einem Bildschirm des Zählers (1; 101) erzeugt wird.

16. Verfahren zum Installieren eines Zählers, der dazu bestimmt ist, einen Verbrauch einer elektrischen Energie zu messen, die von einem Netzwerk (2; 102) an eine elektrische Anlage (3; 103) geliefert wird, wobei der Zähler (1; 101) stromabwärts eines Trennschalters (6; 106) positioniert ist und eine stromaufwärtige Phasenklemme (7a; 107), eine stromabwärtige Phasenklemme (8a; 108) und ein Abschaltorgan (10; 110) umfasst, das zwischen die stromaufwärtige Phasenklemme und die stromabwärtige Phasenklemme geschaltet ist, wobei das Installationsverfahren die Schritte umfasst:
- Öffnen des Trennschalters;
- Verkabeln des Zählers (1; 101);
- Schließen des Trennschalters;
- Veranlassen, dass durch den Zähler das Überprüfungsverfahren nach einem der vorhergehenden Ansprüche durchgeführt wird.

17. Zähler, der dazu bestimmt ist, eine elektrische Energie zu messen, die von einem Netzwerk an eine elektrische Anlage geliefert wird, wobei der Zähler ausgebildet ist, um zu überprüfen, ob seine Verdrahtung korrekt ausgeführt worden ist, wobei der Zähler eine stromaufwärtige Phasenklemme, eine stromabwärtige Phasenklemme und ein Abschaltorgan umfasst, das zwischen die stromaufwärtige Phasenklemme und die stromabwärtige Phasenklemme geschaltet ist, wobei der Zähler einen stromaufwärtigen Spannungssensor umfasst, der ausgebildet ist, um eine stromaufwärtige Phasenspannung stromaufwärts des Abschaltorgans zu messen, einen stromabwärtigen Spannungssensor, der ausgebildet ist, um eine stromabwärtige Phasenspannung stromabwärts des Abschaltorgans zu messen, und Verarbeitungsmittel, die ausgebildet sind, um einen Verdrahtungsfehler in Abhängigkeit von einer Messung der stromaufwärtigen Phasenspannung und einer Messung der stromabwärtigen Phasenspannung zu erfassen, wobei die Verarbeitungsmittel ferner ausgebildet sind, um einen Alarm zu erzeugen, wenn ein Verdrahtungsfehler erfasst wird, und um das Abschaltorgan zu schließen und den Zähler für die elektrische Energie in einen nominalen Betriebsmodus zu versetzen, wenn kein Verdrahtungsfehler erfasst wird.

18. Computerprogramm, umfassend Anweisungen zum Durchführen des Überprüfungsverfahrens nach einem der Ansprüche 1 bis 15 mittels eines Zählers für elektrische Energie.

19. Speichermittel, **dadurch gekennzeichnet, dass** sie ein Computerprogramm speichern, das Anweisungen zum Durchführen des Überprüfungsverfahrens nach einem der Ansprüche 1 bis 15 mittels eines Zählers für elektrische Energie umfasst.

## Claims

1. A verification method for verifying the wiring of a meter for measuring the consumption of electricity supplied by a network (2; 102) to an electrical installation (3; 103), the verification method being intended to verify that the wiring has been correctly carried out, the meter (1; 101) having an upstream phase terminal (7a; 107), a downstream phase terminal (8a; 108), and a cutoff member (10; 110) connected between the upstream phase terminal and the downstream phase terminal, the verification method comprising the following steps:
- opening the cutoff member;
- measuring an upstream phase voltage (Vam) upstream from the cutoff member and measuring a downstream phase voltage (Vav) downstream from the cutoff member;
- detecting a potential wiring error, as a function of a measurement of the upstream phase voltage and a measurement of the downstream phase voltage;
- if a wiring error is detected, generating a warning;
- if no wiring error is detected, closing the cutoff member and putting the meter into a nominal mode of operation.

2. A verification method according to claim 1, wherein the meter is a single-phase meter (1) and wherein the wiring error is also detected as a function of a measurement of a first phase difference between the upstream phase voltage (Vam) and the downstream phase voltage (Vav).

3. A verification method according to claim 2, wherein the wiring error is detected when the following three conditions are satisfied simultaneously:
- the first phase difference (ϕ1) is such that:
180° - x1 ≤ ϕ1 ≤ 180° + x1, where x1 is a first predetermined phase threshold lying in the range 1° to 10°;
- the upstream phase voltage (Vam) is greater than a predefined voltage threshold;
- the downstream phase voltage (Vav) is greater than the predefined voltage threshold.

4. A verification method according to claim 2, wherein the first phase difference is measured by using a "zero crossing" type method.

5. A verification method according to claim 2, further comprising, if the downstream phase voltage (Vav) is greater than a first predefined high-voltage threshold and if the upstream phase voltage (Vam) is less than a first predefined low-voltage threshold, a step that consists in generating a message for verifying whether the electrical installation (3) is or is not an electricity-producing installation.

6. A verification method according to claim 2, further comprising, if the downstream phase voltage (Vav) is greater than a first predefined high-voltage threshold and if the upstream phase voltage (Vam) is greater than a first predefined high-voltage threshold, and if the first phase difference (ϕ1) is such that 360° - x2 ≤ ϕ1 ≤ x2, where x2 is a second predetermined phase threshold lying in the range 1° to 10°, a step that consists in generating a message for verifying whether the electrical installation (3) is or is not an electricity-producing installation.

7. A verification method according to claim 1, wherein the meter is a three-phase meter (101) having three upstream phase terminals (107a, 107b, 107c), three downstream phase terminals (108a, 108b, 108c), and a cutoff member (110a, 110b, 110c) connected between each upstream phase terminal and the corresponding downstream phase terminal, and wherein the wiring error is detected when one of the upstream phase voltages is less than a second predefined low-voltage threshold and when one of the downstream phase voltages is greater than a second predefined high-voltage threshold.

8. A verification method according to claim 7, further comprising, if one of the downstream phase voltages is greater than the second predefined high-voltage thresholds, a step consisting in measuring a second phase difference between the downstream phase voltage greater than the second predefined high-voltage threshold and the corresponding upstream phase voltage, and in measuring a third phase difference between the downstream phase voltage greater than the second predefined high-voltage threshold and another upstream phase voltage.

9. A verification method according to claim 8, further comprising a step consisting in verifying that the second phase difference (ϕ2) and the third phase difference (ϕ3) are such that:
120° - x3 ≤ ϕ2 ≤ 120° + x3 or 240° - x3 ≤ ϕ2 ≤ 240° + x3 and 240° - x3 ≤ ϕ3 ≤ 240° + x3 or 120° - x3 ≤ ϕ3 ≤ 120° + x3, where x3 is a third predetermined phase threshold lying in the range 1° to 10°.

10. A verification method according to claim 8, wherein the second phase difference and the third phase difference are measured by using a "zero crossing" type method.

11. A verification method according to claim 7, further comprising, if an upstream phase voltage is less than the second predefined low-voltage threshold and if the corresponding downstream phase voltage is greater than the second predefined high-voltage threshold, a step consisting in generating a message to verify whether the electrical installation (103) is or is not an electricity-producing installation.

12. A verification method according to claim 7, further comprising, if an upstream phase voltage is greater than the second predefined high-voltage threshold and if the corresponding downstream phase voltage is greater than the second predefined high-voltage threshold, and if a fourth phase difference (ϕ4) between these two voltages is such that 360° - x4 ≤ ϕ4 ≤ x4, where x4 is a fourth predetermined phase threshold lying in the range 1° to 10°, a step consisting in generating a message to verify whether the electrical installation (103) is or is not an electricity-producing installation.

13. A verification method according to claim 1, wherein the warning informs an installer of the meter (1; 101) that the wiring error has been detected.

14. A verification method according to claim 13, wherein the warning is generated by a light-emitting diode of the meter (1; 101).

15. A verification method according to claim 13, wherein the warning is generated by displaying a warning message on a screen of the meter (1; 101).

16. A method of installing a meter for measuring the consumption of electricity supplied by a network (2; 102) to an electrical installation (3; 103), the meter (1; 101) being positioned downstream from a disconnector (6; 106) and having an upstream phase terminal (7a; 107), a downstream phase terminal (8a, 108), and a cutoff member (10; 110) connected between the upstream phase terminal and the downstream phase terminal, the installation method comprising the steps of:
- opening the disconnector;
- wiring the meter (1; 101);
- reclosing the disconnector;
- causing the meter to perform the verification method according to any preceding claim.

17. A meter for measuring electricity supplied by a network to an electrical installation, the meter comprising an upstream phase terminal, a downstream phase terminal, and a cutoff member connected between the upstream phase terminal and the downstream phase terminal, the meter including an upstream voltage sensor arranged to measure an upstream phase voltage upstream from the cutoff member, a downstream voltage sensor arranged to measure a downstream phase voltage downstream from the cutoff member, and processor means arranged to detect a wiring error, in particular as a function of a measurement of the upstream phase voltage and a measurement of the downstream phase voltage, the processor means also being arranged to generate a warning if a wiring error is detected, and to close the cutoff member and put the electricity meter into a nominal mode of operation if no wiring error is detected.

18. A computer program including instructions for enabling an electricity meter to perform the verification method according to any one of claims 1 to 15.

19. Storage means, **characterized in that** they store a computer program including instructions for enabling an electricity meter to perform the verification method according to any one of claims 1 to 15.
